# FASCICULE DE BREVET EUROPEEN

(11) **EP 3 061 181 B1**
(45) Date de publication et mention de la délivrance du brevet: **15.11.2017**
(21) Numéro de dépôt: 14824885.9
(22) Date de dépôt: 23.10.2014
(51) Int. Cl.: H02N 2/18, H01L 41/113, H01L 41/00

(54) **CONVERTISSEUR D'ENERGIE A RECUPERER ET GENERATEUR D'ELECTRICITE**
KONVERTER FÜR ENERGIERÜCKGEWINNUNG UND ELEKTRISCHER GENERATOR
CONVERTER FOR CONVERTING ENERGY TO BE RECOVERED AND ELECTRICITY GENERATOR

(30) Priorité: 25.10.2013 FR 1360430
(43) Date de publication de la demande: 31.08.2016
(73) Titulaire: Commissariat à l'Energie Atomique et aux Energies Alternatives, 75015 Paris (FR); Centre National de la Recherche Scientifique (C.N.R.S.), 75016 Paris (FR)
(72) Inventeur: VIALA, Bernard, F-38360 Sassenage (FR); CUGAT, Orphée, F-38320 Poisat (FR)
(74) Mandataire: Colombo, Michel
(86) Numéro de dépôt international: PCT/FR2014/052704
(87) Numéro de publication internationale: WO 2015/059419

(56) Documents cités:
- WO-A1-2013/042505
- FR-A1- 2 973 578
- PING ET AL: "High efficiency passive magnetoelectric transducer consisting of PZT and Fe-Ni fork substrate with high Q value", SENSORS, 2010 IEEE, 1 novembre 2010 (2010-11-01), pages 178-181, XP031978134, DOI: 10.1109/ICSENS.2010.5690689 ISBN: 978-1-4244-8170-5
- PULLAR: "Hexagonal ferrites: A review of the synthesis, properties and applications of hexaferrite ceramics", PROGRESS IN MATERIALS SCIENCE, vol. 57, no. 7, 20 mars 2012 (2012-03-20), pages 1191-1334, XP028514433, ISSN: 0079-6425, DOI: 10.1016/J.PMATSCI.2012.04.001 [extrait le 2012-04-11]
- PING ET AL: "Effect of adjustable bias voltage on magnetoelectric properties of piezoelectric/magnetostrictive laminate transducer", ULTRASONICS SYMPOSIUM 2012 IEEE, 7 octobre 2012 (2012-10-07), pages 2510-2513, XP032434567, ISSN: 1948-5719, DOI: 10.1109/ULTSYM.2012.0628 ISBN: 978-1-4673-4561-3
- KYUNG ET AL: "Layout design optimization for magneto-electro-elastic laminate composites for maximized energy conversion under mechanical loading", SMART MATERIALS AND STRUCTURES, vol. 19, no. 5, 1 mai 2010 (2010-05-01), page 55008, XP020175678, ISSN: 0964-1726

## Description

L'invention concerne un convertisseur d'une variation d'énergie à récupérer en une différence de potentiels, la variation d'énergie à récupérer étant une variation de champ magnétique ou température. L'invention concerne également un générateur d'électricité équipé de ce convertisseur.

Des convertisseurs connus de variations de champ magnétique ou de température en une différence de potentiels comportent :
- une couche transductrice s'étendant essentiellement parallèlement à un plan de référence et apte à transformer la variation d'énergie à récupérer en une déformation mécanique,
- une couche piézoélectrique présentant des faces intérieure et extérieure parallèles à ce plan de référence, la face intérieure étant fixée sans aucun degré de liberté sur la majorité de la couche transductrice de manière à subir une contrainte mécanique exercée par cette couche transductrice,
- une première et une deuxième électrodes en matériau électriquement conducteur s'étendant essentiellement parallèlement au plan de référence le long d'au moins l'une des faces de la couche en matériau piézoélectrique du deuxième transducteur pour faire apparaître un excédent de charges électriques sur l'une de ces électrodes en réponse à la contrainte mécanique subie par la couche en matériau piézoélectrique.

De tels convertisseurs sont par exemple décrits dans la demande US2004126620A1. Le fonctionnement de ce type de convertisseur est également présenté dans les articles suivants :
- Article A1 :T. Lafont, J. Delamare, G. A. Lebedev, D. I. Zakharov, B. Viala, O. Cugat, L. Gimeno, N. Galopin, L. Garbuio et O. Geoffroy, « Magnetostrictive-piezoelectric composite structures for energy harvesting », Journal of michromechanics and microengeneering, n°22, 2012,
- Article A2 : D. Zakharov, G. Lebedev, O. Cugat, J. Delamare, B. Viala, T. Lafont, L. Gimeno et A. Shelyakov, « Thermal energy conversion by coupled shape memory and piezoelectric effects », PowerMEMS'11, Séoul, Corée, JMM 2012 ;
- article A3 : G. A. LEBEDEV et Al, « Thermal energy harvesting using shape memory/piezoelectric composites », Transducer'11, Beijing, Chine, juin 5-9, 2011.

De l'état de la technique est également connu de :
- PING et Al : « High efficiency passive magnetoelectric transducer consisting of PZT and Fe-Ni fork substrate with high Q value », SENSORS, 2010 IEEE, 2010-11-01, pages 178-181 ;
- FR2973578A1 ;
- PULLAR : « Hexagonal ferrites : A review of the synthesis, properties and applications of hexaferrite ceramics », Progress in material science, vol. 57, n°7, 2012-03-20, pages 1191-1334 ;
- PING et AL : « Effect of adjustable bias voltage on magnetoelectric properties of piezoelectric/magnetostrictive laminate transducer », Ultrasonic symposium 2012 IEEE, 2012-10-07, pages 2510-2513 ;
- KYUNG et AL : « Layout design optimization for magneto-electro-elastic laminate composites for maximized energy conversion under mechanical loading », Smart materials and structures, vol. 19, n°5, 2010-05-01 ; pages 55008 ;
- WO2013/042505A1.

L'invention vise à accroître l'efficacité du convertisseur. L'efficacité est ici définie comme étant la quantité d'énergie électrique produite pour une même variation de l'énergie à récupérer.

Elle a donc pour objet un convertisseur conforme à la revendication 1.

L'utilisation de plusieurs premiers blocs présentant chacun un axe préférentiel de déformation parallèle au plan de référence permet de produire une déformation plus grande de la couche piézoélectrique en réponse à une variation de l'énergie à récupérer que si un seul bloc était utilisé. Ainsi, cela permet d'accroître l'efficacité du convertisseur.

Dans cet description, par « axe préférentiel de déformation », on désigne l'axe colinéaire à la direction dans laquelle le taux d'élongation ΔL/L est maximal pour une variation donnée de température ou de champ magnétique et au moins deux fois supérieur au taux d'élongation mesuré simultanément dans une direction perpendiculaire parallèle au plan de référence, où ΔL est l'amplitude de la déformation du premier bloc mesurée dans une direction donnée, et L est la longueur du bloc dans cette direction donnée

Les modes de réalisation de ce convertisseur peuvent présenter une ou plusieurs des caractéristiques des revendications dépendantes de convertisseur.

Ces modes de réalisation du convertisseur présentent en outre les avantages suivants :
- l'utilisation de seconds blocs dont le coefficient de magnétostriction est de signe opposé à celui des premiers blocs augmente l'efficacité du convertisseur ;
- l'utilisation de premier blocs en matériau à mémoire de forme dont les axes préférentiel de déformation se coupe sur l'axe de rotation permet d'exercer une contrainte mécanique plus uniforme sur la couche piézoélectrique et donc d'augmenter l'efficacité du convertisseur ;
- l'utilisation d'une seconde couche piézoélectrique symétrique de la première couche piézoélectrique limite la flexion du convertisseur dans une direction perpendiculaire au plan de référence et maintient une déformation plane;
- le fait que les blocs de la couche transductrice soient uniformément répartis autour de l'axe de rotation uniformise la répartition des contraintes exercées sur la couche piézoélectrique et permet d'augmenter l'efficacité du convertisseur,
- le fait que les blocs de la couche transductrice soient alignés sur un même axe permet de transformer efficacement un mouvement de translation des sources d'énergie à récupérer en une différence de potentiels,
- le fait que les axes préférentiels de déformation soient parallèles à des directions différentes du plan de référence permet de simultanément étirer et, en alternance, rétrécir la même couche piézoélectrique dans différentes directions, ce qui augmente la quantité d'électricité produite,
- l'utilisation d'un treillis de fils en matériau magnétostrictif ou à mémoire de forme permet de réaliser simplement un bloc en matériau magnétostrictif ou à mémoire de forme ayant au moins un axe préférentiel de déformation le long duquel l'amplitude de la déformation est beaucoup plus importante que dans les autres directions.

L'invention a également pour objet un générateur d'électricité conforme à la revendication indépendante de générateur.

Le fait d'utiliser simultanément plusieurs premiers blocs et plusieurs premières sources d'énergie à récupérer disposés les uns par rapport aux autres pour que dans la première position, les contraintes mécaniques exercées par chacun des premiers blocs soient simultanément maximales, permet d'augmenter la quantité de charges électriques générées par un déplacement du convertisseur revendiqué par rapport au cas où le convertisseur comporte uniquement un seul bloc en matériau magnétostrictif ou à mémoire de forme. La seconde position permet d'alterner entre la première position où les contraintes mécaniques sont maximales et la seconde position où les contraintes mécaniques sont moindres ou de signe opposé. Grâce à cela, la différence de potentiels produite par le convertisseur varie au fur et à mesure que l'ensemble de sources d'énergie à récupérer alterne entre les première et seconde positions. Il est donc possible de produire de l'énergie électrique à chaque déplacement de l'ensemble par rapport au convertisseur. En absence de telles variations de la contrainte, la production d'énergie électrique serait impossible.

Les modes de réalisation de ce générateur peuvent comporter une ou plusieurs des caractéristiques des revendications dépendantes de générateur.

Ces modes de réalisation du générateur présentent en outre les avantages suivants :
- la présence des secondes sources de champ magnétique ou de seconds blocs en matériau magnétostrictif intercalés entre les premiers blocs, permet d'augmenter l'amplitude de la variation de la différence de potentiels entre les première et seconde positions ce qui augmente l'efficacité du générateur ;
- l'utilisation de sources locales de chaleur déplaçable entre les premiere et seconde positions permet de générer de l'énergie électrique même si la température des sources de chaleur ne varie pas.

L'invention sera mieux comprise à la lecture de la description qui va suivre, donnée uniquement à titre d'exemple non limitatif et faite en se référant aux dessins sur lesquels :
- la figure 1 est une illustration schématique, partiellement en coupe verticale, d'un générateur d'électricité,
- la figure 2 est une illustration, en vue de dessus, d'un ensemble d'aimants permanents utilisé dans le générateur de la figure 1,
- la figure 3 est une illustration schématique, en coupe verticale, d'un convertisseur utilisé dans le générateur de la figure 1,
- la figure 4 est une illustration schématique, en vue de dessus, du convertisseur de la figure 3,
- la figure 5 est une illustration schématique, en vue de dessus, d'une couche transductrice utilisée dans le convertisseur de la figure 3,
- les figures 6, 7, 8 et 11 sont des illustrations schématiques, en vue de dessus, de différents autres modes de réalisation de la couche transductrice de la figure 5 ;
- la figure 9 est une illustration schématique, en vue de dessus, d'un agencement d'un ensemble d'aimants permanents susceptible d'être utilisé à la place de l'agencement d'aimants permanents de la figure 2 dans le cas particulier de la couche magnétostrictive de la figure 8 ;
- la figure 10 est une illustration schématique, en vue de dessus, d'un autre mode de réalisation du générateur de la figure 1 dans le cas d'un mouvement en translation ;
- la figure 12 est une illustration schématique et partielle, en coupe verticale, d'un autre mode de réalisation d'un générateur d'électricité,
- la figure 13 est une illustration schématique et partielle, en vue de dessus, d'un ensemble de sources de champ magnétique du générateur de la figure 12,
- la figure 14 est une illustration schématique et partielle, en vue en coupe verticale, d'un autre mode de réalisation d'un source de champ magnétique de la figure 13 ;
- la figure 15 est une illustration schématique, en vue de dessus, d'un mode de réalisation d'une couche transductrice dans le cas où la variation d'énergie à récupérer est une variation de température ;
- la figure 16 est une illustration schématique, en vue de dessus, d'un mode de réalisation d'une source d'énergie à récupérer produisant une variation de température ;
- les figures 17 et 18 sont des illustrations schématiques de portions de treillis utilisées pour former des blocs d'une couche transductrice.

Dans ces figures, les mêmes références sont utilisées pour désigner les mêmes éléments.

Dans la suite de cette description, les caractéristiques et fonctions bien connues de l'homme du métier ne sont pas décrites en détail.

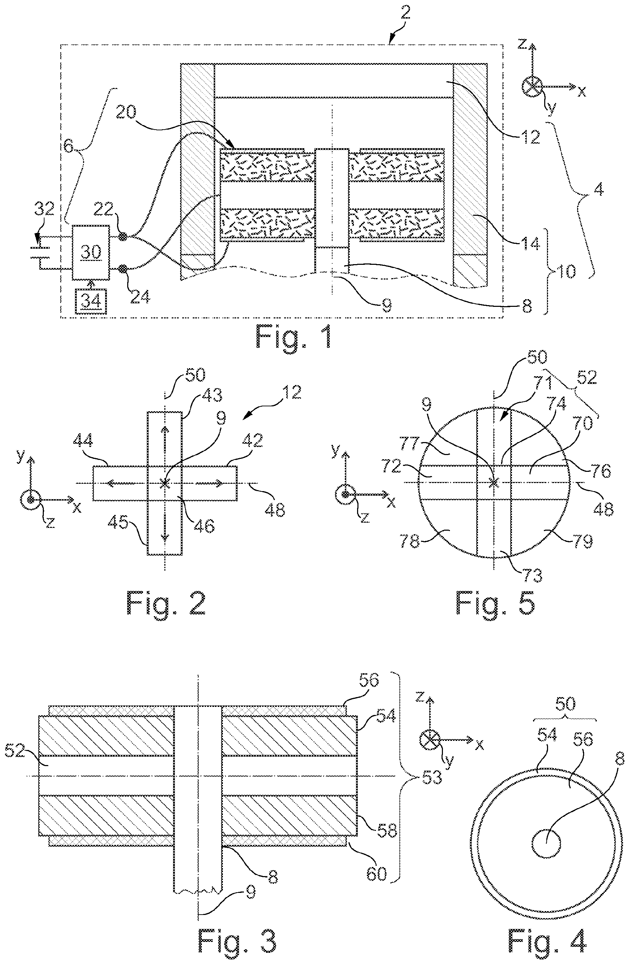

La figure 1 représente un générateur 2 d'électricité. Ce générateur 2 comporte :
- une source 4 d'énergie à récupérer, et
- un récupérateur 6 d'énergie propre à transformer l'énergie à récupérer en énergie électrique.

Ici, l'énergie à récupérer est une rotation d'un champ magnétique. Par exemple, le champ magnétique tourne autour d'un axe Z vertical d'un repère orthogonal X, Y, Z. Par la suite, chacune des figures est orientée par rapport à ce repère X, Y, Z.

Dans ce mode de réalisation, la source 4 comprend :
- un arbre 8 entraîné en rotation autour d'un axe vertical 9 et sur lequel est fixé sans aucun degré de liberté un convertisseur 20 du récupérateur 6 d'énergie, et
- un ensemble 12 de sources uni-axiales de champ magnétique fixé sans aucun degré de liberté sur un châssis immobile à proximité du convertisseur 20.

L'arbre 8 est l'arbre d'un appareil 10. L'appareil 10 est par exemple un compteur de liquide ou de gaz et l'arbre 8 est l'arbre de cet appareil entraîné en rotation lors du comptage du liquide ou du gaz consommé. Pour simplifier, seule une partie de l'appareil 10 est représentée.

Le récupérateur 6 d'énergie comporte :
- le convertisseur 20 qui convertit le champ magnétique tournant en un excédent correspondant de charges électriques sur une borne 22 ou 24 de raccordement par rapport à l'autre de ces bornes 22, 24.
- un circuit 30 de collecte de l'excédent de charges électriques sur la borne 22 ou 24 et de transfert de ces charges électriques collectées vers un élément électrique 32, et
- un circuit 34 de commande du circuit 30 de collecte.

L'élément 32 est un élément de stockage ou de consommation ou de transmission d'électricité. Il comporte un ou plusieurs composants électriques. Par exemple, l'élément 32 est un condensateur qui stocke l'énergie électrique récupérée.

Le circuit 30 de collecte et le circuit 34 de commande sont, par exemple, identiques à ceux décrits dans la demande WO 2007/063194 et, de préférence, identiques à l'un de ceux décrits dans la demande déposée sous le n° FR 1260047, le 22 octobre 2012 par le Commissariat à l'énergie atomique et aux énergies alternatives. Par conséquent, ces circuits 30 et 34 ne sont pas décrits ici plus en détail.

La figure 2 représente plus en détail l'ensemble 12. Ici, chaque source de champ magnétique de l'ensemble 12 correspond à un aimant permanent uni-axial. Par « uni-axial », on désigne le fait que chaque source présente un seul moment magnétique. Sur la figure 2 et les figures suivantes, le moment magnétique de chaque aimant permanent est représenté par une flèche. Toutefois, le sens dans lequel est dirigé ce moment magnétique n'a pas forcément d'importance car un matériau magnétostrictif n'est pas sensible au sens des lignes de champ. Les aimants permanents de l'ensemble 12 sont fixés les uns par rapport aux autres sans aucun degré de liberté de manière à ce que l'ensemble 12 présente simultanément et en permanence plusieurs moments magnétiques dont les projections orthogonales dans un plan horizontal sont décalées angulairement les unes par rapport aux autres autour de l'axe 9.

Ici, l'ensemble 12 comporte quatre aimants permanents 42 à 45. Sur la figure 2, les moments magnétiques des aimants 42 et 44 sont parallèles à la direction X et les moments magnétiques des aimants 43 et 45 sont parallèles à la direction Y. Plus précisément, dans la position représentée, les moments magnétiques des aimants 42 et 44 sont alignés au-dessus d'un axe horizontal 48 parallèle à la direction X et coupant l'axe 9. Dans le même temps, les moments magnétiques des aimants 43 et 45 sont alignés au-dessus d'un axe horizontal 50 parallèle à la direction Y et coupant l'axe 9. Les aimants 42 et 44 sont symétriques l'un de l'autre par rapport à un plan vertical passant par l'axe 50. De façon similaire, les aimants 43 et 45 sont symétriques l'un de l'autre par rapport à un plan vertical passant par l'axe 48. Ici, les aimants 42 à 45 sont disposés à chaque extrémité d'une croix. De plus, dans ce mode de réalisation, l'ensemble 12 comporte un aimant centrale 46 situé sur l'axe 9 et accolé aux pôles nord des aimants 42 à 45. Le moment magnétique de cet aimant 46 est vertical et situé sur l'axe 9. Il renforce les lignes de champ des aimants 42 à 45 vers la couche 52.

Le convertisseur 20 va maintenant être décrit plus en détail en référence aux figures 3 à 5. Ce convertisseur 20 est capable de transformer en électricité des variations très lentes de l'énergie à récupérer. Par « variation lente », on désigne des variations dont la fréquence fondamentale est inférieure à 1 Hz ou 10 Hz. A cet effet, le convertisseur 20 convertit une variation de l'amplitude du champ magnétique variable dans une direction donnée en une génération d'un excédent de charges sur la borne 22 et, en alternance, sur la borne 24. Cette conversion se fait presque instantanément de sorte que la tension entre les bornes 22 et 24 varie en même temps et au fur et à mesure que l'amplitude du champ magnétique variable varie dans une direction donnée.

Dans ce mode de réalisation, le convertisseur 20 comporte une couche transductrice 52 associée à un transducteur électromécanique 53.

La couche 52 s'étend dans un plan horizontal appelé « plan de référence ». Elle est réalisée, au moins en partie, dans un matériau magnétostrictif. Ici, par « matériau magnétostrictif », on désigne un matériau dont la valeur absolue maximale du coefficient de magnétostriction λₛ, à saturation, est supérieure à 10 ppm (partie par million) et, de préférence, supérieure à 100 ou 1000 ppm. Le coefficient λₛ est défini par la relation suivante : λₛ = ΔL/L, où :
- ΔL est le taux d'élongation du matériau magnétostrictif le long de son axe préférentiel de déformation, et
- L est la longueur de ce matériau dans cette direction en absence de champ magnétique extérieur.

Dans ce mode de réalisation, le coefficient λₛ est positif. Par exemple, le matériau magnétostrictif est le Terfenol-D ou le FeSiB ou un alliage de FeCo. La couche 52 est décrite plus en détail en référence à la figure 5.

Le transducteur électromécanique 53 comprend :
- une couche horizontale supérieure 54 en matériau piézoélectrique,
- une électrode extérieure 56,
- une couche horizontale inférieure 58 en matériau piézoélectrique, et
- une électrode extérieure 60.

Dans le cas particulier décrit ici, la couche 52 est également électriquement conductrice. Dans ces conditions, la couche 52 remplit également la fonction d'électrode intérieure pour chacune des couches 54, 58.

La couche 58 et l'électrode 60 sont les symétriques, respectivement, de la couche 54 et de l'électrode 56 par rapport à un plan horizontal situé à mi-hauteur de la couche 52. Par conséquent, cette couche et cette électrode ne sont pas décrites plus en détail.

La couche 54 s'étend horizontalement sur toute la face du dessus de la couche 52. Plus précisément, elle présente une face intérieure collée sans aucun degré de liberté sur cette face du dessus de la couche 52. Cette face intérieure recouvre la majorité et, typiquement, plus de 90 % ou 98 % de la face du dessus de la couche 52. Ici, la couche 54 s'étend uniformément dans chaque direction horizontale. La couche 54 se comporte mécaniquement comme un seul bloc de matière. Par exemple, dans ce mode de réalisation, la couche 54 a la forme d'un disque horizontal traversé en son centre par l'axe 9.

La couche 54 comporte également une face extérieure horizontale située du côté opposé à la face intérieure.

Lors de son fonctionnement, la couche 54 génère un excédent de charges électriques sur la face extérieure quand la couche 52 exerce une contrainte mécanique sur la face intérieure. Ce mode de fonctionnement est connu sous le terme de mode d₃₁. Dans ce mode de fonctionnement, la capacité du transducteur 53 est importante, ce qui améliore et facilite le fonctionnement du convertisseur 20. Typiquement, ce mode de fonctionnement de la couche 54 est obtenu avec un matériau piézoélectrique polarisé verticalement dans le même sens sur toute sa face intérieure.

Ici, le matériau piézoélectrique présente un coefficient de couplage k supérieur à 5 % ou 10 %. Ce coefficient de couplage est défini dans la norme ANSI/IEEE 176-1987 « ANSI/IEEE Standard on Piezoelectricity » ou dans les normes de la famille EN 50-324. Plus précisément, ici le matériau piézoélectrique utilisé présente un coefficient piézoélectrique g₃₁ supérieur à 5 x 10⁻³Vm/N et, de préférence, supérieur à 10 x 10⁻³Vm/N ou 100 x 10⁻³Vm/N ou 200 x 10⁻³Vm/N à 25° C. Ici, le matériau piézoélectrique est du PZT (Titano-Zyrconate de Plomb) ou du PMN-PT (lead magnésium niobate-lead titanate)PVDF (Polyfluorure de Vinylidène).

L'électrode 56 est réalisée dans un matériau électriquement conducteur. Ici, par matériau électriquement conducteur, on désigne un matériau dont la résistivité à 25° C est inférieure à 10⁻⁵ Ω.m et de préférence inférieure à 10⁻⁶ Ω.m ou 10⁻⁷ Ω.m. L'électrode 56 est directement déposée sur la face extérieure de la couche 54. Typiquement, elle recouvre la majorité de cette face extérieure et, de préférence, plus de 70 % ou 80 % de cette face extérieure. Ici, l'électrode 56 est réalisée à l'aide d'une couche d'un seul tenant en matériau électriquement conducteur qui recouvre la majorité de la face extérieure de la couche 54. Plus précisément, dans ce mode de réalisation, l'électrode 56 forme un anneau entourant l'arbre 8.

La figure 5 représente plus en détail la structure de la couche 52. La couche 52 est un disque de même rayon que la couche 54. Elle comporte quatre blocs 70 à 73 s'étendant le long de deux axes horizontaux se coupant sur l'axe 9. L'angle entre ces axes horizontaux est choisi égal à l'angle existant entre les directions des moments magnétiques de l'ensemble 12 à plus ou moins 10° ou 5° près et, de préférence, à plus ou moins 2° près. Sur la figure 5, la couche 52 est représentée dans une première position particulière où les blocs 70 à 73 s'étendent, respectivement, le long des axes 48 et 50 orthogonaux entre eux. Plus précisément, les blocs 70 et 72 sont alignés sur l'axe 48 tandis que les blocs 71 et 73 sont alignés sur l'axe 50.

Les blocs 70 à 73 sont réalisés dans le même matériau magnétostrictif. De plus, chaque bloc 70 à 73 présente son propre axe préférentiel de déformation. L'axe préférentiel de déformation d'un bloc magnétostrictif est l'axe le long duquel l'amplitude de sa déformation est maximale lorsqu'il est traversé par des lignes de champ parallèles à cet axe.

Pour certain matériau mégnétostrictif, lorsque les lignes de champ saturent magnétiquement le bloc magnétostrictif, l'axe préférentiel de déformation est parallèle à ces lignes de champ. Dans cette situation, l'axe préférentiel de déformation est imposé par la disposition du bloc magnétostrictif par rapport à la source de ces lignes de champ. Lorsque le bloc en matériau magnétostrictif n'est pas saturé magnétiquement, l'axe préférentiel de déformation peut aussi être une propriété intrinsèque du bloc magnétostrictif qui est due, par exemple, à l'orientation cristalline du matériau magnétostrictif et/ou au facteur de forme du bloc. Ici, par « facteur de forme », on désigne le rapport de la longueur sur la largeur du rectangle horizontale de plus petite surface à l'intérieur duquel est contenu le bloc.

Ici, typiquement, le facteur de forme de chaque bloc est strictement supérieure à 1 ou 1,5 ou 2 et, dans certain cas, à 10. L'axe préférentiel de déformation est alors parallèle à la longueur du bloc. Ainsi, dans les modes de réalisation décrits ci-dessous, à défaut d'indication contraire, l'axe préférentiel de déformation de chaque bloc est systématiquement confondu avec son axe longitudinal.

ici, chaque bloc 70 à 73 est rectangulaire. Ils sont tous situés dans le plan de référence.

De plus, dans ce mode de réalisation, la couche 52 comprend aussi une partie centrale 74 qui relie mécaniquement les blocs 70 à 73 entre eux. Cette partie centrale peut également être réalisée dans le même matériau magnétostrictif que les blocs 70 à 73.

De préférences, les blocs 70 à 73 représentent la majorité de la surface horizontale de la couche 52. A cet effet, la largeur de chaque bloc 70 à 73 est supérieure à 1/5 et, de préférence, supérieure à 1/3 du rayon de la couche 52. Ici, le bloc 72 est le symétrique du bloc 70 par rapport à l'axe 9. De même, le bloc 73 est le symétrique du bloc 71 par rapport à cet axe 9. De plus, le bloc 71 est identique au bloc 70 à l'exception du fait qu'il est décalé angulairement de 90° par rapport à ce bloc 70.

Dans la première position, chaque bloc 70 à 73 est en vis-à-vis d'un aimant 42 à 45 respectif. Par exemple, dans cette première position, pour chaque bloc 70 à 73, la surface de l'intersection entre les projections orthogonales sur le plan de référence de ce bloc et d'un aimant permanent respectif de l'ensemble 12 est supérieure ou égale à plus de 50 % et, de préférence, à plus de 80 % ou 90 % de la surface de ce bloc dans ce plan. Dans ces conditions, on dit que ce bloc est situé à l'intérieur de la projection orthogonale de l'aimant permanent. Par la suite, cette même définition est utilisée pour définir ce que l'on entend par le fait qu'un élément est en vis-à-vis d'un aimant permanent.

Dans ce mode de réalisation, la couche 52 comporte également quatre régions 76 à 79 dépourvues de matériau magnétostrictif et intercalées entre les blocs 70 à 73. Les bords latéraux de ces blocs 70 à 73 sont donc mécaniquement séparés des bords latéraux des autres blocs immédiatement adjacents par ces quatre régions 76 à 79.

La région 76 est délimitée d'un côté par un bord latéral du bloc 70 et de l'autre côté par un bord latéral du bloc 71. Sa périphérie extérieure est alignée avec un bord vertical des couches 54 et 58. Les régions 77, 78 et 79 sont identiques à la région 76 sauf qu'elles sont décalées angulairement autour de l'axe 9, respectivement, de 90°, 180° et 270°. Ainsi, dans ce mode de réalisation, chaque région a essentiellement la forme d'un secteur angulaire dont l'angle au sommet est égal à 90°. L'épaisseur de chacune de ces régions 76 à 79 est égale à l'épaisseur des blocs 70 à 73. Dans la première position, ces régions sont situées en dehors des projections orthogonales des aimants permanents de l'ensemble 12. On considère qu'un élément est situé en dehors de la projection orthogonale d'un aimant permanent s'il n'est pas en vis-à-vis de cet aimant avec la définition donnée ci-dessus.

Le fonctionnement du générateur 2 va maintenant être décrit. Dans la première position représentée sur la figure 5, les blocs 70 à 73 sont traversés par des lignes de champ parallèles à leur axe préférentiel respectif de déformation. En réponse, la déformation, ici l'allongement, des blocs 70 à 73 est maximale. La couche 52 exerce donc dans cette première position des contraintes maximales en tension sur les couches 54 et 58 en même temps le long des axes 48 et 50. Ainsi, dans les zones de la face extérieure des couches 54 et 58 situées à la verticale des blocs 70 à 73, un excédent de charges électriques de même signe est produit. De plus, étant donné que les couches 54 et 58 sont rigides, les zones des couches 54 et 58 situées à la verticale des régions 76 à 79 sont également soumises à une contrainte en tension de sorte que la face extérieure de ces couches 54 et 58 présentent également des zones générant un excédent de charges électriques de même signe. Dès lors, dans cette première position, des charges électriques de même signe sont générées sur quasiment la totalité de la face extérieure des couches 54 et 58, ce qui accroît la différence de potentiels produite par le convertisseur 20.

Lorsque le convertisseur 20 fait 1/8 de tour autour de l'axe 9 depuis la première position, une seconde position est atteinte. Dans cette seconde position, les blocs 70 à 73 sont situés à mi-distance entre deux aimants consécutifs de l'ensemble 12. De plus, dans ce mode de réalisation, les directions des moments magnétiques de l'ensemble 12 sont décalées angulairement de 45° par rapport aux axes préférentiels de déformation des blocs 70 à 73. Dans cette seconde position, ce sont les régions 76 à 79 qui sont en vis-à-vis des aimants 42 à 45. Puisque ces régions 76 à 79 sont dépourvues de matériau magnétostrictif, les blocs 70 à 73 ne tendent plus à s'allonger mais, au contraire, ils se rétrécissent simultanément pour revenir vers une position de repos. La position de repos est la position qui serait obtenue en absence de champ magnétique. Ainsi, dans cette seconde position, les contraintes mécaniques exercées par les blocs 70 à 73 sur les couches 54 et 58 sont minimales.

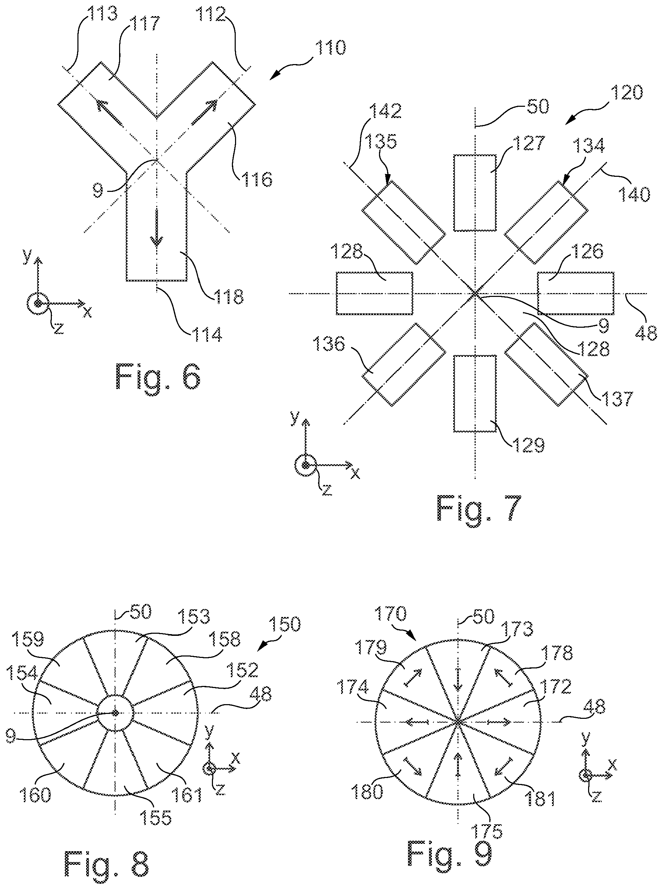

La figure 6 représente l'agencement d'une couche transductrice 110 susceptible d'être utilisée à la place de la couche 52 dans le convertisseur 20. Ici, le nombre d'axes préférentiels de déformation de la couche transductrice est égal à trois. Plus précisément, la couche 110 est identique à la couche 52, sauf qu'elle comporte trois blocs 116 à 118 qui s'étendent, respectivement, le long d'axes 112 à 114. Ici, ces axes 112 à 114 sont décalés angulairement les uns par rapport aux autres de 120° de sorte que le décalage angulaire entre ces axes est uniformément réparti autour de l'axe 9. Dans ce mode de réalisation, le matériau magnétostrictif de la couche 110 présente une forme de « Y ».

Lorsque la couche 110 est utilisée, l'ensemble 12 est remplacé par un ensemble d'aimants permanents agencés les uns par rapport aux autres pour qu'il existe au moins une position dans laquelle chacun de ces aimants est en vis-à-vis d'un bloc respectif de la couche 110. De plus ces trois aimants permanents sont agencés pour présenter simultanément trois moments magnétiques horizontaux dont les décalages angulaires entre eux sont identiques aux décalages angulaires existant entre les axes 112 à 114. Pour simplifier la figure 6, seule la projection orthogonale de ces trois moments magnétiques sur le plan de référence est représentée par trois flèches en gras. Avec un tel ensemble d'aimants permanents, le fonctionnement d'un convertisseur incorporant la couche 110 est identique au fonctionnement décrit pour le convertisseur 20. Toutefois, la seconde position où la contrainte exercée par les blocs 116 à 118 est minimale est atteinte après une rotation de 60° autour de l'axe 9 depuis la première position représentée sur la figure 6.

La figure 7 représente une couche transductrice 120 susceptible d'être utilisée à la place de la couche 52 dans le convertisseur 20. Cette couche 120 est identique à la couche 52 sauf que les blocs 70 à 73 sont remplacés par des blocs 126 à 129. Ces blocs 126 à 129 sont par exemple identiques, respectivement, aux blocs 70 à 73. Dans la première position représentée sur la figure 7, les blocs 126 à 129 sont donc en vis-à-vis, respectivement, des aimants permanents 42 à 45.

Dans ce mode de réalisation, les régions qui séparent les blocs 126 à 129 comportent chacune, respectivement, un bloc 134 à 137 en matériau magnétostrictif différent de celui utilisé pour réaliser les blocs 126 à 129. Plus précisément, les blocs 134 à 137 sont réalisés dans un matériau magnétostrictif dont le coefficient λₛ de magnétostriction est de signe opposé au matériau magnétostrictif utilisé pour réaliser les blocs 126 à 129. Par exemple, il s'agit ici du SamFeNol qui est un alliage de Samarium à coefficient de magnétostriction négatif.

Ici, l'agencement des blocs 134 et 136 est identique à l'agencement des blocs 126 et 128, sauf qu'ils sont décalés angulairement de +45° autour de l'axe 9. De même, l'agencement des blocs 135 et 137 est le même que celui des blocs 126 et 128 sauf qu'ils sont décalés angulairement de -45° autour de l'axe 9. Ainsi, les blocs 134 et 136 sont alignés sur un axe horizontal 140 incliné de +45° par rapport à l'axe 48 et les blocs 135 et 137 sont alignés sur un axe horizontal 142 incliné de -45° par rapport à l'axe 48. Les axes préférentiels de déformations des blocs 134 et 136 sont alignés sur l'axe 140 tandis que les axes préférentiels de déformation des blocs 135 et 137 sont alignés sur l'axe 142.

La couche 120 est conçue pour fonctionner avec l'ensemble 12 d'aimants permanents. Les blocs 126 à 129 fonctionnent comme décrit en référence aux figures 1 à 5. Toutefois, dans la seconde position, les blocs 134 à 137 se retrouvent en vis-à-vis des aimants 42 à 45. Dans cette seconde position, les axes préférentiels de déformation des blocs 134 à 137 sont alignés avec les moments magnétiques de l'ensemble 12. Dès lors, les blocs 134 à 137 se rétrécissent ce qui exerce des contraintes en compression dans les zones des couches 54 et 58 situées à la verticale de ces blocs 134 à 137. A cause de la rigidité des couches 54 et 58, le rétrécissement des blocs 134 à 137 génère également une contrainte en compression dans les zones des couches 54 et 58 situées à la verticale des blocs 126 à 129. Ainsi, dans cette seconde position, presque la totalité de la surface intérieure des couches 54 et 58 est soumise à une contrainte en compression. Cela permet donc d'augmenter l'amplitude entre les différences de potentiels produites dans les première et seconde positions par rapport au mode de réalisation de la figure 1 et donc d'augmenter l'efficacité du convertisseur.

La figure 8 représente, dans une première position, une couche transductrice 150 susceptible d'être utilisée à la place de la couche 52 dans le convertisseur 20. Cette couche 150 est identique à la couche 52 sauf que les blocs 70 à 73 sont remplacés par des blocs 152 à 155. Dans la première position, les blocs 152, 154 s'étendent le long de l'axe 48 et les blocs 153, 155 s'étendent le long de l'axe 50. Les axes longitudinaux des blocs 152 à 155 sont alignés sur les axes le long desquels ils s'étendent. Le bloc 152 a essentiellement la forme d'un secteur angulaire dont le sommet est situé sur l'axe 9 et dont la bissectrice est confondue avec l'axe 48 dans la première position. L'angle au sommet du bloc 152 est égal à 45°. Ici, le sommet de ce secteur angulaire est supprimé pour laisser un passage pour l'axe 8. Les blocs 153 à 155 sont identiques au bloc 152 sauf qu'ils sont décalés angulairement autour de l'axe 9 par rapport au bloc 52 de, respectivement, 90°, 180° et 270°. Avec ce choix de la valeur de l'angle au sommet du bloc 152, les régions 158 à 161 dépourvues de matériau magnétostrictif sont aussi des secteurs angulaires de même forme que le bloc 152 mais décalées angulairement autour de l'axe 9, respectivement, de 45°, 135°, 225° et 315° par rapport à la position du secteur angulaire du bloc 152.

La figure 9 représente un ensemble 170 d'aimants permanents destiné à remplacer l'ensemble 12 lorsque la couche 52 est remplacée par la couche 150. L'ensemble 170 est identique à l'ensemble 12 sauf que les aimants permanents 42 à 45 sont remplacés par, respectivement, des aimants permanents 172 à 175. Les aimants 172 à 175 ont chacun la même forme que les blocs 152 à 155 et sont agencés les uns par rapport aux autres comme décrit pour les blocs 152 à 155. Toutefois, le sommet du secteur angulaire de chaque aimant n'a pas été supprimé pour laisser un passage pour l'axe 8. Ainsi, dans la première position, chaque bloc 152 à 155 est en vis-à-vis d'un aimant 172 à 175 respectif. Les directions des moments magnétiques des aimants 172 et 174 sont alignées sur l'axe 48. A l'inverse, les directions des moments magnétiques des aimants 173 et 175 sont alignées sur l'axe 50.

En vis-à-vis des régions 158 à 161, dans la première position, l'ensemble 170 comporte des aimants permanents supplémentaires, respectivement, 178 à 181. Chacun de ces aimants 178 à 181 à la même forme que l'aimant 172. Ces aimants 178 à 181 sont décalés angulairement autour de l'axe 9 de, respectivement, 45°, 135°, 225° et 315° par rapport à la position de l'aimant 172. Ainsi, après une rotation de 45° de la couche 150 pour atteindre une seconde position, chaque bloc 152 à 155 se trouve en vis-à-vis d'un aimant 178 à 181 respectif.

La direction des moments magnétiques des aimants 178 à 181 est choisie pour que les lignes de champ magnétique qu'ils génèrent à l'intérieur des blocs 152 à 155 dans la seconde position soient tournées de 90°, dans un plan horizontal, par rapport aux lignes de champs magnétique que génèrent les aimants 172 à 175 à l'intérieur de ces mêmes blocs mais dans la première position. Pour cela, la direction du moment magnétique de chaque aimant 178 à 181 est perpendiculaire à la bissectrice du secteur angulaire occupé par cet aimant et dont l'angle au sommet est situé sur l'axe 9.

Lors du fonctionnement de la couche 150, dans la première position, les blocs 152 à 155 s'allongent radialement et exercent simultanément une contrainte en tension sur la face intérieure des couches 54 et 58 comme décrit pour la couche 52. Dans la seconde position, les blocs 152 à 155 sont en vis-à-vis cette fois ci des aimants 178 à 181. Dans cette seconde position, les lignes de champs magnétiques qui traversent les blocs 152 à 155 sont perpendiculaires aux axes longitudinaux de ces blocs. Des lors dans la seconde position, chaque bloc 152 à 155 s'allonge dans la direction des lignes de champ qui le traversent ce qui correspond à un rétrécissement dans la direction horizontale perpendiculaire à son axe longitudinal. Ainsi, les blocs 152 à 155 exercent un contrainte en compression radiale sur les couches 54 et 58. Comme dans le mode de réalisation de la figure 7, cela permet donc d'augmenter l'amplitude entre les différences de potentiels produites dans les première et seconde positions.

Les modes de réalisation décrits jusqu'à présent, l'ont été dans le cas particulier où le convertisseur tourne par rapport à l'ensemble d'aimants permanents. Toutefois, tout ce qui a été décrit dans ce contexte particulier, s'applique également au cas où l'ensemble d'aimants permanents se déplace en translation par rapport au convertisseur parallèlement au plan de référence. Pour passer d'un mode de réalisation à l'autre, il suffit de « dérouler » les structures décrites dans le cas d'un mouvement rotatif pour obtenir le mode de réalisation correspondant dans le cas d'un mouvement de translation.

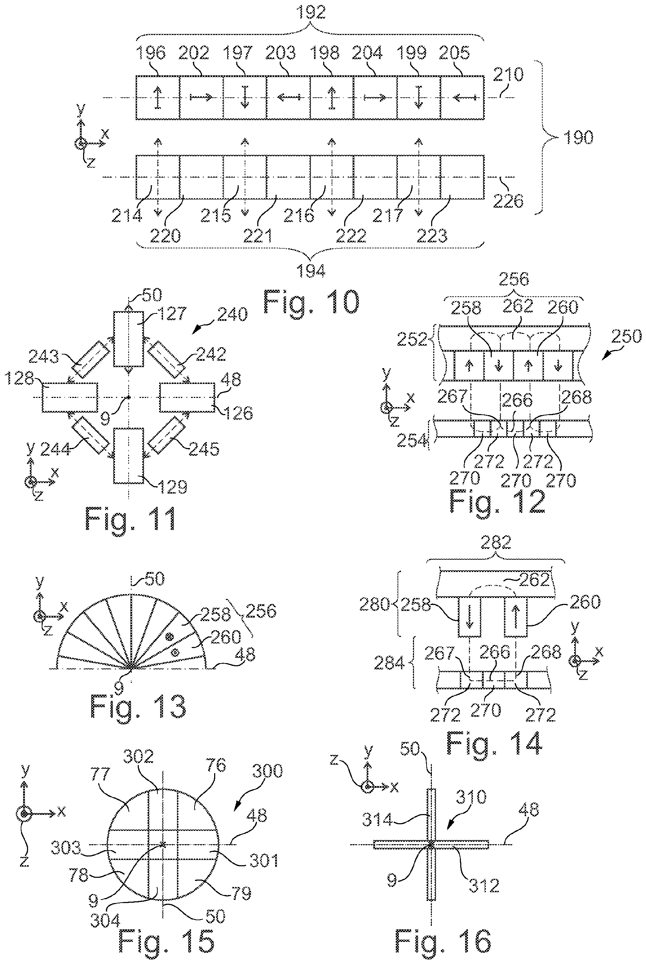

Par exemple, la figure 10 représente un générateur 190 correspondant au mode de réalisation des figures 8 et 9 mais avec un mouvement de translation. Pour simplifier la figure 10, seules les principaux éléments qui diffèrent par rapport au générateur 2 sont représentés. Plus précisément, dans le générateur 190, l'ensemble 12 est remplacé par un ensemble 192 d'aimants permanents et la couche 52 est remplacée par une couche 194. La couche 194 est interposée entre deux couches en matériaux piézoélectriques similaires aux couches 54 et 58. Sur la figure 10, l'ensemble 192 et la couche 194 sont représentés en vue de dessus et l'un à côté de l'autre. Dans la réalité, l'ensemble 192 et la couche 194 sont superposés verticalement l'un au-dessus de l'autre.

L'ensemble 192 comprend quatre aimants permanents 196 à 199 et quatre aimants permanents 202 à 205. Tous ces aimants sont placés sur un même axe 210 parallèle à la direction X. Les aimants 202 à 204 sont interposés entre, respectivement, les aimants 196, 197, les aimants 197, 198 et les aimants 198, 199. L'aimant 205 est accolé, sur la droite, à l'aimant 199. Les aimants 196 à 199 ont chacun un moment magnétique uni-axial parallèle à la direction Y. Les aimants 202 à 205 ont chacun un moment magnétique uni-axial parallèle à la direction X. Tous les aimants ont la même largeur dans la direction X.

La couche 194 comporte quatre blocs 214 à 217 dans le même matériau magnétostrictif séparés par quatre régions 220 à 223 dépourvues de matériau magnétostrictif. Ces blocs et régions sont tous alignés sur un axe 226 parallèle à la direction X. Plus précisément, les régions 220 à 222 sont interposées entre, respectivement, les blocs 214, 215, les blocs 215, 216 et les blocs 216, 217. La région 223 est ici accolée sur la droite du bloc 223. Cette région 223 peut aussi être omise. Les axes préférentiels de déformation des blocs 214 à 217 sont parallèles à la direction Y.

L'ensemble 192 et la couche 194 sont déplaçables l'un par rapport à l'autre entre une première position, représentée sur la figure 10, et une seconde position. Dans la seconde position, la couche 194 est décalée d'un pas vers la gauche, dans la direction X, par rapport à la première position. Ici, ce pas est égal à la largeur d'un aimant permanent de l'ensemble 192.

Dans la première position, les blocs 214 à 217 sont situés en vis-à-vis des aimants 196 à 199 et les régions 220 à 223 sont situées en vis-à-vis des aimants 202 à 205. Dans la seconde position, ce sont les régions 220 à 223 qui sont situées en vis-à-vis des aimants 196 à 199 et les blocs 215 à 217 qui sont situés en vis-à-vis des aimants 202 à 204. Dans cet exemple, dans la seconde position, le bloc 214 n'est en vis-à-vis d'aucun élément.

Dans l'agencement décrit, les aimants 196 à 199 correspondent fonctionnellement aux aimants 172 à 175 et les aimants 202 à 205 correspondent fonctionnellement aux aimants 178 à 181. De même, les blocs 214 à 217 correspondent fonctionnellement aux blocs 152 à 155 et les régions 220 à 223 correspondent fonctionnellement aux régions 158 à 155. Ainsi, le fonctionnement du générateur 190 se déduit du fonctionnement de la couche 150 avec l'ensemble 170 sauf qu'ici la génération d'électricité est provoquée par un déplacement en translation selon la direction X de la couche 194 par rapport à l'ensemble 192 et non pas par un mouvement de rotation.

La figure 11 représente une couche transductrice 240 destinée à remplacer la couche 120. Cette couche 240 est identique à la couche 120 sauf que les blocs 134 à 137 sont remplacés par des blocs en matériau magnétostrictif, respectivement, 242 à 245. Les blocs 242 à 245 sont réalisés dans un matériau magnétostrictif dont le coefficient de magnétostriction est de même signe que celui des blocs 126 à 129. Typiquement, les blocs 242 à 245 sont réalisés dans le même matériau magnétostrictif que les blocs 126 à 129. Ici, chaque bloc 242 à 245 est conformé de manière à présenter un axe préférentiel de déformation confondu avec son axe longitudinal. Les blocs 242 et 244 sont disposés, respectivement, entre les blocs 126, 127 et les blocs 128, 129 de sorte que leurs axes préférentiels de déformation soient perpendiculaires à plus ou moins 10° ou 5° près à l'axe 48 dans la seconde position. De façon similaire, les blocs 243 et 245 sont disposés entre, respectivement, les blocs 127, 128 et les blocs 129, 126 de sorte que leurs axes préférentiels de déformation soient perpendiculaires à plus ou moins 10° ou 5° près à l'axe 50 dans la seconde position. Dans ces conditions, les blocs 242 à 245 remplissent la même fonction que les blocs 134 à 137. En effet, dans la seconde position, chacun de ces blocs 242 à 245 exerce une contrainte en compression sur les couches 54 et 58 car les lignes de champ traversent ces blocs 242 à 245 perpendiculairement à leur axe préférentiel de déformation dans la seconde position.

Les figures 12 et 13 représentent un générateur 250 identique au générateur 2 sauf que :
- l'ensemble 12 est remplacé par un ensemble 252 de sources de champ magnétique, et
- la couche 52 est remplacée par une couche transductrice 254.

Pour simplifier la figure 12 seuls les éléments différents sont représentés. Sur la figure 13, seule une moitié de l'ensemble 252 est illustrée.

Dans l'ensemble 252 chaque source de champ magnétique est réalisée à l'aide de deux aimants permanents et non pas d'un seul. Ces sources sont décalées angulairement les unes par rapport aux autres dans un plan horizontal pour être uniformément réparties autour de l'axe 9. A part cette différence, les sources sont identiques les unes aux autres. Ainsi, seule une source 256 de l'ensemble 252 va maintenant être décrite en détail. La source 256 comporte deux aimants permanents uni-axiaux 258, 260. Les moments magnétiques de ces deux aimants 258, 260 sont verticaux et de sens opposé. Dans ce mode de réalisation, ils sont accolés l'un à l'autre. Du côté opposé à la couche 254, la source 256 comporte une portion de culasse 262 en matériau magnétique qui raccorde magnétiquement les deux pôles supérieurs des aimants 258 et 260. Dans ces conditions, la source 256 génère un champ magnétique qui se reboucle, du côté supérieure, par l'intermédiaire de la culasse 262 et, du côté inférieur, par l'intermédiaire de la couche 254. A l'intérieur de la couche 254, ce champ magnétique s'étend le long de lignes de champ 266 parallèles au plan de référence et, à chaque extrémité de ces lignes 266, le long de lignes de champ 267 et 268 parallèles à la direction Z à plus ou moins 20° ou 10° près.

De préférence, les aimants 258 et 260 sont communs aux sources de l'ensemble 252 situées immédiatement en amont et en aval de la source 256.

Dans la première position représentée sur la figure 12, la couche 254 comporte, comme dans les modes de réalisation précédents, des blocs 270 en matériau magnétostrictif situés en vis-à-vis de chaque source de l'ensemble 252. Ici, la projection orthogonale de la source 256 sur la plan de référence comprend la projection orthogonale des aimants 258, 260. De plus, étant donné que les aimants 258, 260 sont commun à deux sources immédiatement adjacentes, ces projections orthogonales de ces deux sources sont à cheval l'une sur l'autre. Dans ce mode de réalisation, en plus d'être en vis-à-vis de la source 256 dans la première position, le bloc 270 est uniquement situé à l'emplacement des lignes de champ 266. De préférence, les lignes de champ 266 sature magnétiquement le bloc 270. Ainsi, dans ce mode de réalisation, l'axe préférentiel de déformation du bloc 270 est parallèle aux lignes de champ 266 dans la première position. Cet axe préférentiel de déformation est donc perpendiculaire à un rayon de la couche 250 et donc parallèle à la direction X dans la position représentée sur la figure 12. Ainsi, dans ce mode de réalisation, l'axe préférentiel de déformation n'est pas parallèle à l'axe longitudinal du bloc 270.

Des régions 272 sont intercalées entre chaque paire de blocs 270 adjacents. Ces régions 272 sont, par exemple, dépourvues de matériau magnétostrictif. De part leur disposition par rapport aux blocs 270, les régions 272 sont essentiellement traversées par des lignes de champ 267, 268 verticales dans la première position. Ainsi, dans la première position, les blocs 270 sont essentiellement traversés par les lignes de champ 266 horizontales et parallèles à leur axe préférentiel de déformation. Les blocs 270 s'étirent donc horizontalement. Ainsi, dans la première position, les couches 54 et 58 sont uniquement soumises à des contraintes en tension exercées par les blocs 270.

La seconde position est atteinte après une rotation autour de l'axe 9 d'un angle égal à l'angle au sommet d'un bloc 270. Dans la seconde position, ce sont les régions 272 qui sont traversées par les lignes de champ 266 horizontales tandis que les blocs 270 sont traversés par les lignes de champ verticales 267, 268. Dans cette position, tous les blocs 270 se rétractent horizontalement. Ainsi, tous les blocs 270 exercent simultanément des contraintes en compression sur les couches 54 et 58.

La figure 14 représente un ensemble 280 de sources 282 de champ magnétique susceptible de remplacer l'ensemble 252 du générateur 250. Chaque source 282 est identique à la source 256 sauf que les aimants 258, 260 sont espacés horizontalement l'un de l'autre par une distance, par exemple, supérieure à d/2 ou d, où d est la largeur de l'aimant 258 dans un plan horizontal. Lorsque l'ensemble 280 est utilisé, la couche 254 est remplacée par une couche 284. La couche 284 est identique à la couche 254 sauf que les dimensions des blocs 270 et des régions 272 sont ajustées pour tenir compte de l'espace qui existe entre les aimants 258 et 260. Le fonctionnement de l'ensemble 280 avec la couche 284 est le même que celui décrit en référence aux figures 12 et 13. On notera cependant que dans ce mode de réalisation, la projection orthogonale de la source 282 sur la plan de référence comprend la projection orthogonale des aimants 258, 260 ainsi que de l'espace situé entre ces deux aimants.

La figure 15 représente un couche transductrice 300 destinée à remplacer la couche 52 lorsque la variation d'énergie à récupérer est une variation de température. La couche 300 est ici identique à la couche 52 sauf que les blocs 70 à 73 sont remplacés, respectivement, par des blocs 301 à 304. Dans ce mode de réalisation, les blocs 301 à 304 sont identiques aux blocs 70 à 73 sauf qu'ils sont réalisés dans un matériau à mémoire de forme. L'axe préférentiel de déformation des blocs 301 et 303 est parallèle, dans la première position représentée sur la figure 15, à l'axe 48. Dans cette première position, l'axe préférentiel de déformation des blocs 302 et 304 est parallèle à l'axe 50. Comme dans le cas des blocs en matériau magnétostrictif, l'axe préférentiel de déformation est ici l'axe le long duquel l'amplitude de la déformation est maximale en réponse à une variation donnée de température. De plus, comme pour les blocs en matériau magnétostrictif, lorsque le bloc en matériau à mémoire de forme se contracte le long de son axe préférentiel de déformation, il s'allonge simultanément le long d'un axe horizontal perpendiculaire. Chaque bloc 301 à 304 est ici configurée pour qu'en réponse à une augmentation de la température extérieure, il se contracte le long de son axe préférentiel de déformation et, simultanément, s'allonge le long d'un autre axe perpendiculaire. Toutefois, dans le cas des matériaux à mémoire de forme la direction de l'axe préférentiel de déformation est une caractéristique intrinsèque du bloc configurée lors de sa fabrication. Ainsi, la direction de l'axe préférentiel de déformation des blocs 301 à 304 ne dépend pas de leur position relative par rapport à la source d'énergie à récupérer. Ici, le matériau à mémoire de forme présente un taux d'allongement, le long de son axe préférentiel de déformation, au moins supérieur à 0,5% ou 1 % en réponse à une variation de température de 10° ou de 20°C. Pour plus d'informations sur les matériaux à mémoire de forme utilisables dans un tel convertisseur, il est possible de se référer aux articles A2 et A3.

Dans le cas où la couche 300 est utilisée dans le convertisseur, l'ensemble 12 d'aimants permanents est remplacé par un ensemble 310 de sources de chaleur représenté sur la figure 16. L'ensemble 310 comporte deux sources 312 et 314 de chaleur. Les sources 312 et 314 s'étendent uniquement le long, respectivement, des axes 48 et 50 de manière à chauffer essentiellement les blocs en vis-à-vis de ces axes tout en chauffant beaucoup moins les régions qui ne sont pas en vis-à-vis de ces axes. Par exemple, dans cette première position, pour chaque bloc 301 à 304, la surface de l'intersection entre les projections orthogonales sur le plan de référence de ce bloc et de la source en vis-à-vis de l'ensemble 310 est supérieure ou égale à plus de 30 % ou 50 % et, de préférence, à plus de 80 % ou 90 % de la surface de ce bloc dans ce plan.A titre d'illustration, les sources 312 et 314 sont des tuyaux parcourus par un fluide caloporteur. Les sources 312 et 314 peuvent aussi être des filaments ou des résistances chauffantes. Dans ce mode de réalisation, comme la couche 300 tourne par rapport à l'ensemble 310, la température des sources 312 et 314 est, par exemple, constante. Les blocs 301 à 304 sont chauffés quand ils se trouvent en vis-à-vis des sources 312 et 314 et se refroidissent quand ils sont en vis-à-vis des régions 76 à 79. Le fonctionnement du générateur équipé de la couche 300 et de l'ensemble 310 se déduit des explications données en référence aux figures 2 à 4.

De nombreux autres modes de réalisation sont possibles. Par exemple, l'électrode 56 n'a pas besoin d'être formée d'un seul bloc de matière. En variante, l'électrode 56 comprend plusieurs plots conducteurs répartis sur la face extérieure de la couche 54 et séparés mécaniquement les uns des autres par des tranchées remplies d'un matériau électriquement isolant, des conducteurs électriques raccordant en série ces différents plots.

En variante, une électrode intérieure en matériau électriquement conducteur est interposée entre les couches 52 et 54. Cela s'avère nécessaire dans tout mode de réalisation où la couche transductrice est réalisée dans un matériau qui n'est pas électriquement conducteur.

Les électrodes extérieures ne sont pas nécessairement directement fixées sur la couche en matériau piézoélectrique. Par exemple, elles peuvent être séparées de cette couche par une fine couche intermédiaire, par exemple ayant une épaisseur inférieure à 1/100-ième ou 1/1000-ième de l'épaisseur de la couche piézoélectrique. Elles peuvent également être légèrement mobiles par rapport à la couche en matériau piézoélectrique.

Jusqu'à présent seul le mode d₃₁ de la couche en matériau piézoélectrique a été utilisé. En variante, il est possible d'utiliser une couche en matériau piézoélectrique fonctionnant selon le mode d₃₃. Par exemple, le transducteur piézoélectrique est réalisé comme décrit en référence à la figure 3 de l'article A1 précédemment cité. Autrement dit, une couche en matériau piézoélectrique polarisé horizontalement est utilisée. Dans la première position, la ou les directions de polarisation sont parallèles aux axes préférentiels de déformation des blocs. Les électrodes utilisées sont alors formées d'un ou plusieurs peignes. Chaque peigne est composé de plusieurs doigts en matériau électriquement conducteur s'étendant chacun parallèlement à une direction perpendiculaire à la direction de polarisation de la couche piézoélectrique. Chaque peigne d'un électrode est entrelacé ou « interdigité » avec un peigne correspondant de l'autre électrode pour former une configuration connue sous le terme anglais de « Interdigitated combs ». Dans l'article A1, chaque électrode comporte deux paires de peignes disposés, respectivement, sur les faces extérieure et intérieure de la couche en matériau piézoélectrique. Toutefois, lorsque la couche en matériau piézoélectrique fonctionne en mode d₃₃, toutes les électrodes peuvent être placées sur une même face de la couche en matériau piézoélectrique. Il peut s'agir de la face intérieure ou extérieure de la couche en matériau piézoélectrique. Il est aussi possible de placer un seul peigne sur chaque face de la couche piézoélectrique, ces peignes étant alors décalés l'une par rapport à l'autre dans la direction de polarisation de la couche piézoélectrique.

La couche 54 en matériau piézoélectrique peut présenter d'autres formes. Par exemple, avantageusement, elle peut également être conformée en forme d'ellipse plutôt que de disque. La section horizontale de cette couche 54 peut également, en variante, être carrée ou rectangulaire ou être un polygone à plus de cinq sommets.

La couche piézoélectrique n'est pas non plus nécessairement en un seul bloc. Par exemple, elle peut aussi être réalisée par l'accolement les uns à côté des autres de plusieurs blocs en matériau piézoélectrique. Toutefois même dans ce cas, les différents blocs de la couche piézoélectrique sont fixés les uns aux autres sans aucun degré de liberté de manière à se comporter mécaniquement comme un seul bloc de matière. Typiquement, tous les blocs de matériau piézoélectrique sont polarisés dans le même sens.

D'autres matériaux piézoélectrique que le PZT ou le PMN-PT peuvent être utilisés. Par exemple, le matériau piézoélectrique peut être du PVDF (Polyfluorure de Vinylidène). Dans ce cas, l'épaisseur de la couche 54 est inférieure à 300 µm et, de préférence, inférieure à 100 µm ou 30 µm ou 20 µm. Généralement, l'épaisseur « e » de cette couche est supérieure à 10 µm. Le choix d'une fine couche en PVDF permet d'augmenter le rendement du convertisseur 20. Le matériau piézoélectrique peut aussi être une mousse piézoélectrique telle que l'une de celles décrites dans l'article suivant :
Imran Patel, « Ceramic based intelligent piezoelectric energy harversting device », Intechopen, 6 septembre 2011..

Chaque aimant permanent peut être réalisé dans un seul bloc de matière. Chaque aimant permanent peut aussi être composé d'un empilement les unes sur les autres de plusieurs lames aimantées, chaque lame de l'empilement présentant un moment magnétique parallèle à celui des autres lames de cet empilement. Le sens du moment magnétique d'une lame par rapport à celui des autres lames du même empilement n'a pas d'importance car le matériau magnétostrictif est uniquement sensible à la direction du moment magnétique et non pas à son sens.

L'ensemble 12 peut être réalisé sans utiliser d'aimants permanents. Par exemple, il peut être réalisé en utilisant des bobines parcourues par un courant.

Les aimants permanents de l'ensemble 12 peuvent être disposés dans un plan qui n'est pas nécessairement parallèle au plan de référence. Dans une autre variante, les directions des moments magnétiques des sources de l'ensemble ne sont pas toutes coplanaires.

L'aimant 46 peut être omis.

Les directions des moments magnétiques peuvent être modifiées. Par exemple, dans le mode de réalisation de la figure 10, les directions des moments magnétiques de tous les aimants 196 à 199 et 202 à 205 sont tournées de 45° vers la droite. On conserve ainsi un décalage angulaire de 90° entre les moments magnétiques de deux aimants immédiatement consécutifs. L'axe préférentiel de déformation des blocs 214 à 217 est alors aussi tourné de 45°. Le fonctionnement de cette variante reste le même que celui décrit en référence à la figure 10. De façon similaire, les directions des moments magnétiques et des axes de déformation de l'ensemble 170 peuvent aussi être tournées. De même, les directions des moments magnétiques des aimants dans les autres modes de réalisation peuvent être modifiées à partir du moment où, dans la première position, la contrainte mécanique exercée sur les zones des couches piézoélectriques à la verticale des blocs sont toutes de même signe. Ces modifications des directions des moments magnétiques peuvent ou non être accompagnées de modifications correspondantes des directions des axes préférentiels de déformation des blocs.

Le nombre de blocs en matériau magnétostrictif et le nombre de sources de champ magnétique peut être supérieur à quatre, huit ou douze. Ce nombre peut être très grand notamment dans le cas d'un déplacement linéaire comme décrit en référence à la figure 10. De préférence, si le déplacement entre les première et seconde positions se fait par rotation, alors le nombre de blocs est inférieur à douze. Toutefois, si le nombre de blocs de la couche transductrice est strictement supérieur à douze, alors il est possible de prévoir dans chaque région séparant les différents blocs de la couche transductrice un mécanisme limitant ou éliminant les couplages magnétiques susceptibles d'exister entre ses différents blocs.

Les différents blocs de la couche transductrice ne s'étendent pas nécessairement dans le même plan. Dans ce cas, le plan de référence est le plan médian aux différents plans dans lesquels s'étendent ces différents blocs et l'on considère la projection orthogonale d'un bloc sur ce plan de référence pour savoir si celui-ci est situé à l'intérieur de la projection orthogonale d'une source uni-axiale de champ magnétique.

Si un matériau magnétostrictif à coefficient de magnétostriction négatif est utilisé à la place d'un matériau magnétotrictif à coefficient de magnétostriction positif, dans la première position, le signe des contraintes mécaniques exercées par les blocs est inversé par rapport à ce qui a été décrit dans le cas d'un matériau magnétostrictif à coefficient de magnétostriction positif.

Les différents blocs en matériau magnétostrictif ayant des coefficients de magnétostriction de même signe ne sont pas nécessairement réalisé dans le même matériau magnétostrictif.

Le matériau magnétostrictif peut aussi être remplacé par un alliage à mémoire de forme magnétique tel que le NiMnGa, c'est-à-dire un matériau qui travaille comme décrit pour les précédents matériaux à mémoire de forme sauf que la déformation est déclenchée par une variation du champ magnétique et non pas par une variation de température.

Les différents modes de réalisation précédemment décrits peuvent être combinés. Par exemple, l'ensemble 170 peut être utilisé avec la couche 120 ou 240. Conformément à l'enseignement du mode de réalisation de la figure 7, les régions 220 à 223 peuvent être remplacées par des blocs en matériau magnétostrictif dont les coefficients de magnétostriction sont négatifs et dont les axes préférentiels de déformation sont parallèles à ceux des blocs 214 à 217.

Les différentes variantes décrites ci-dessus dans le cas particulier de blocs en matériau magnétostrictif peuvent être adaptées au cas des blocs en matériau à mémoire de forme. De plus, dans le cas des blocs en matériau à mémoire de forme, il est possible de faire varier la température de ces blocs sans déplacer la couche 300 par rapport à des sources locales de chaleur. Pour cela, par exemple, l'ensemble 310 est remplacé par une source de chaleur capable de chauffer de la même manière et simultanément l'ensemble des blocs 301 à 304 et dont la température varie au cours du temps.

Chaque bloc de la couche transductrice n'est pas nécessairement un bloc plein. En variante, ce bloc est ajouré. Par exemple, le bloc est formé par un treillis de fils s'étendant dans le plan de référence. Les fils du treillis sont réalisés :
- soit dans un matériau magnétostrictif pour former un bloc en matériau magnétostrictif,
- soit dans un matériau à mémoire de forme pour former un bloc en matériau à mémoire de forme.
Chaque treillis comporte plus d'une dizaine ou d'une cinquantaine de fils qui s'entrecroisent. Chaque fil présente un facteur de forme supérieur à dix ou trente et, généralement, supérieur à cinquante. Fréquemment, les fils les plus longs s'étendent principalement dans une direction parallèle à l'axe préférentiel de déformation de ce bloc. Par exemple, les fils les plus longs sont au moins deux fois et, de préférence, dix fois plus long que d'autres fils du treillis qui s'entendent dans d'autres directions.

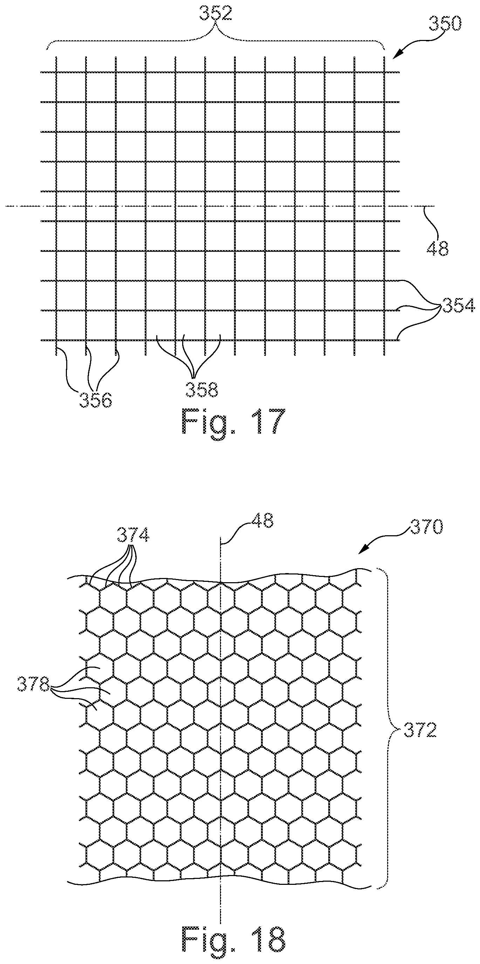

La figure 17 représente un bloc 350 en matériau à mémoire de forme susceptible de remplacer l'un quelconque des blocs 301 à 304 de la couche transductrice 300. Sur la figure 17, le bloc 350 est représenté dans une position où il s'étend principalement le long de l'axe 48. Le bloc 350 est formé d'un treillis 352 de fils en matériau à mémoire de forme. Dans le cas particulier représenté, le treillis 352 comporte uniquement des fils rectilignes 354 qui s'étendent parallèlement à l'axe 48 et des fils rectilignes 356 qui s'étendent uniquement perpendiculairement à l'axe 48. L'entrecroisement des fils 354 et 356 forme donc des mailles 358 de section horizontale rectangulaire. Dans l'exemple représenté, la section des mailles 358 est carrée. Ici, les fils 354 et 356 sont structurellement identiques sauf que les fils 354 sont, typiquement, deux ou cinq fois plus long que les fils 356. Sur la figure 17, ce facteur d'échelle entre les longueurs des fils 354 et 356 n'est pas respecté pour simplifier l'illustration. A chaque croisement entre les fils, ces fils sont fixés mécaniquement l'un à l'autre sans aucun degré de liberté.

De nombreuses formes de mailles sont possibles pour le treillis. Par exemple, la figure 18 représente un bloc 370 formé par un treillis 372 dans lequel des fils 374 s'entrecroisent pour former des mailles 378 dont la section horizontale est hexagonale ou en forme de nid d'abeille. Sur cette figure, les traits ondulés indiquent que seule une partie du bloc a été représentée. Dans le treillis 372, les fils 374 s'étendent principalement dans une direction parallèle à l'axe préférentiel de déformation du bloc 370. Ces fils 374 se chevauchent ou sont confondus l'un avec l'autre au niveau des arêtes de chaque maille 378 parallèles à l'axe 48. Ici, tous les fils 374 ont, par exemple, la même longueur et il n'existe pas d'autres fils s'étendant dans une direction perpendiculaire à l'axe 48. Dans d'autres modes de réalisation, la section horizontale des mailles est un losange.

Dans les exemples précédents, les mailles 358 et 378 ont des facteurs de forme égaux à un. Dans ce cas, la maille ne présente pas en elle-même de direction privilégiée de déformation et c'est donc le facteur de forme du bloc qui fait apparaître un axe préférentiel de déformation. Ici, le « facteur de forme » d'une maille est le rapport de la longueur sur la largeur du rectangle horizontal de plus petite surface à l'intérieur duquel est entièrement contenu la maille. Dans des modes de réalisations préférés, le facteur de forme des mailles est supérieur à 1,5 ou 2 ou 5. Par exemple, les mailles sont rectangulaires. Dans ce dernier cas où les mailles sont plus longues que larges, chaque maille présente en elle-même une direction privilégiée de déformation dans la direction dans laquelle la maille est plus longue. De préférence, la direction privilégiée de déformation de la maille est parallèle à l'axe préférentiel de déformation du bloc. Une telle configuration permet d'augmenter l'amplitude de la déformation du bloc le long de son axe préférentiel de déformation. Si le bloc présente un facteur de forme égale à un, la présences de mailles ayant des directions privilégiées de déformation parallèles permet de créer un axe préférentiel de déformation parallèle à ces directions privilégiées. Ainsi, l'utilisation d'un treillis avec des mailles dont le facteur de forme est strictement supérieur à un est un exemple de mode de réalisation qui permet d'obtenir un bloc ayant un axe préférentiel de déformation sans pour autant que ce bloc présente un facteur de forme strictement supérieur à un.

Les fils n'ont pas nécessairement une section transversale circulaire. Cette section transversale peut aussi être rectangulaire. Dans ce dernier cas, les fils sont de fines bandes de matériau magnétostrictif ou à mémoire de forme.

Il n'est pas nécessaire que les fils les plus long s'étendent parallèlement à l'axe préférentiel de déformation. Par exemple, dans un autre mode de réalisation, des premiers fils rectilignes sont inclinés de +45° par rapport à l'axe 48 et des second fils rectilignes sont inclinés de -45° par rapport à l'axe 48. Ces premiers et seconds fils ont tous la même longueur ou, en variante, des longueurs différentes. Dans ce cas, l'axe préférentiel de déformation reste parallèle à l'axe 48 alors qu'aucun des premiers et seconds fils ne s'étend parallèlement à cet axe.

Tout ce qui a été décrit pour des treillis avec des fils en matériau à mémoire de forme s'applique à l'identique à des treillis avec des fils en matériau magnétostrictif.

Il est aussi possible d'interposer une couche piézoélectrique entre deux couches transductrices. Par exemple, plusieurs convertisseurs 20 centrés sur l'axe 9 peuvent être empilés les uns au dessus des autres dans la direction verticale.

Le convertisseur peut également être monté au bout de l'arbre 8 de sorte que les couches piézoélectrique et transductrice ne sont pas traversées par cet arbre 8.

Le mouvement relatif de l'ensemble 12 par rapport au convertisseur 20 peut également être obtenu en fixant l'ensemble 12 sans aucun degré de liberté sur l'extrémité de l'axe 8 et en fixant le convertisseur 20 sur le châssis immobile 14.

L'appareil 10 peut être un roulement mécanique. Dans ce cas, l'axe 8 est l'axe de ce roulement et le châssis 14 est le châssis du roulement.

## Revendications

1. Convertisseur d'une variation d'énergie à récupérer en une différence de potentiels entre deux bornes électriques, la variation d'énergie à récupérer étant une variation de champ magnétique ou de température, ce convertisseur comportant :
- une couche transductrice (52; 110; 120; 150; 194; 240; 254; 284; 300) s'étendant essentiellement parallèlement à un plan de référence et apte à transformer la variation d'énergie à récupérer en une déformation mécanique, cette couche transductrice comportant à cet effet :
• plusieurs premiers blocs (70-73 ; 116-118 ; 126-129 ; 152-155 ; 214-217 ; 270 ; 301-304) en matériau magnétostrictif ou à mémoire de forme, ces premiers blocs étant délimités les uns des autres par des bords latéraux, et
• des régions (76-79) dépourvues de premier bloc, ces régions étant intercalées entre les bords latéraux de ces premiers blocs (70-73 ; 116-118 ; 126-129 ; 152-155 ; 214-217 ; 270 ; 301-304),
- une couche piézoélectrique (54, 58) formée d'un seul bloc en matériau piézoélectrique ou de plusieurs blocs en matériau piézoélectrique accolés les uns à côté des autres et fixés les uns aux autres sans aucun degré de liberté de manière à se comporter mécaniquement comme un seul bloc de matière, cette couche piézoélectrique présentant des faces intérieure et extérieure parallèles au plan de référence, la face intérieure étant fixée sans aucun degré de liberté sur la majorité de la couche transductrice de manière à subir une contrainte mécanique exercée par cette couche transductrice,
- une première (56 ; 60) et une deuxième (52) électrodes en matériau électriquement conducteur s'étendant essentiellement parallèlement au plan de référence le long d'au moins l'une des faces de la couche piézoélectrique pour faire apparaître un excédent de charges électriques sur l'une de ces électrodes en réponse à la contrainte mécanique subie par la couche piézoélectrique, et les premiers blocs (70-73 ; 116-118 ; 126-129 ; 152-155 ; 214-217 ; 270 ; 301-304) présentent chacun un axe préférentiel de déformation parallèle au plan de référence.

2. Convertisseur selon la revendication 1, dans lequel les premiers blocs sont réalisés en matériau magnétostrictif et ont des coefficients de magnétostriction de même signe et la couche transductrice comporte des seconds blocs (134-137) en matériau magnétostrictif intercalés entre les bords latéraux des premiers blocs (126-129), les coefficients de magnétostriction des seconds blocs étant de signe opposé aux coefficients de magnétostriction des premiers blocs.

3. Convertisseur selon la revendication 1, dans lequel les premiers blocs (301-304) sont réalisés en matériau à mémoire de forme et tous les premiers blocs sont uniformément répartis autour d'un axe de rotation perpendiculaire au plan de référence et leurs axes préférentiels de déformation se coupent sur l'axe de rotation.

4. Convertisseur selon l'une quelconque des revendications précédentes, dans lequel le convertisseur comporte également une seconde couche piézoélectrique (58) symétrique de la première couche piézoélectrique (54) par rapport à un plan de symétrie parallèle au plan de référence, ce plan de symétrie étant situé à mi-hauteur de la couche transductrice.

5. Convertisseur selon l'une quelconque des revendications précédentes, dans lequel chaque premier bloc (70-73; 116-118; 126-129; 152-155; 214-217; 270; 301-304) présente, dans un plan parallèle au plan de référence, un facteur de forme supérieur à deux.

6. Convertisseur selon l'une quelconque des revendications précédentes, dans lequel les axes préférentiels de déformation sont répartis le long d'au moins deux directions différentes du plan de référence.

7. Convertisseur selon l'une quelconque des revendications 1 à 5, dans lequel tous les premiers blocs sont uniformément répartis autour d'un axe de rotation perpendiculaire au plan de référence ou dans lequel tous les premiers blocs sont uniformément répartis sur un axe de translation parallèle au plan de référence.

8. Convertisseur selon l'une quelconque des revendications précédentes, dans lequel au moins l'un des premiers blocs comporte un treillis de fils parallèles au plan de référence, les fils de ce treillis étant réalisés en matériau magnétostrictif ou en matériau à mémoire de forme.

9. Générateur d'électricité comprenant :
- un convertisseur (20) d'une variation d'énergie à récupérer en une différence de potentiels entre deux bornes électriques, la variation d'énergie à récupérer étant une variation de champ magnétique ou de température, et
- un ensemble (12 ; 170 ; 192 ; 252; 280 ; 310) de plusieurs premières sources (42-45 ; 172-175 ; 196-199 ; 256 ; 282 ; 312, 314) d'énergie à récupérer fixées les unes aux autres sans aucun degré de liberté, chaque première source générant localement de l'énergie à récupérer,
**caractérisé en ce que** :
- le convertisseur est conforme à l'une quelconque des revendications précédentes, et
- au moins l'un de l'ensemble et du convertisseur est déplaçable en alternance, à l'intérieur du plan de référence, entre :
• une première position dans laquelle les premiers blocs sont chacun disposés en vis-à-vis d'une première source respective d'énergie à récupérer, et
• une seconde position dans laquelle les régions sont chacune disposées en vis-à-vis d'une première source respective et chaque premier bloc est situé à mi-distance entre deux premières sources.

10. Générateur selon la revendication 9, dans lequel :
- les premiers blocs (70-73; 116-118; 126-129; 152-155; 214-217; 270) sont réalisés en matériau magnétostrictif et ont des coefficients de magnétostriction de même signe,
- les premières sources sont des sources (42-45 ; 172-175 ; 196-199 ; 256 ; 282) de champ magnétique fixées les unes aux autres sans aucun degré de liberté, chaque première source étant apte, dans la première position, à générer à l'intérieur du premier bloc en vis-à-vis, des lignes de champ parallèles au plan de référence et à l'axe préférentiel de déformation de ce premier bloc.

11. Générateur selon la revendication 10, dans lequel l'ensemble comporte en plus des secondes sources (178-181 ; 202-205) de champ magnétique, intercalées entre les premières sources (172-175 ; 196-199), ces secondes sources étant en vis-à-vis d'un premier bloc respectif dans la seconde position, chaque seconde source étant apte, dans la seconde position, à générer à l'intérieur du premier bloc en vis-à-vis des lignes de champ parallèle au plan de référence et perpendiculaire, à plus ou moins 10° près, à l'axe préférentiel de déformation de ce premier bloc.

12. Générateur selon la revendication 10 ou 11, dans lequel la couche transductrice comporte des seconds blocs (134-137) en matériau magnétostrictif intercalés entre les bords latéraux des premiers blocs (126-129), chaque second bloc étant situé, dans la seconde position, en vis-à-vis d'une première source respective de champ magnétique, les coefficients de magnétostriction des seconds blocs étant de signe opposé aux coefficients de magnétostriction des premiers blocs.

13. Générateur selon la revendication 9, dans lequel :
- les premiers blocs (301-304) sont réalisé en matériau à mémoire de forme,
- les premières sources sont des sources (312, 314) de chaleur fixées les unes aux autres sans aucun degré de liberté, chaque première source étant apte, dans la première position, à chauffer le premier bloc en vis-à-vis plus que les régions situées de part et d'autre de ce premier bloc.

14. Générateur selon l'une quelconque des revendications 9 à 13, dans lequel l'ensemble (12 ; 100 ; 170 ; 252; 280 ; 310) de sources est déplaçable en rotation, par rapport au convertisseur, autour d'un axe (9) de rotation perpendiculaire au plan de référence pour passer entre les première et seconde positions, et les premières sources sont uniformément réparties autour de l'axe de rotation.

15. Générateur selon l'une quelconque des revendications 9 à 13, dans lequel l'ensemble (192) de sources est déplaçable en translation, par rapport au convertisseur, le long d'un axe (210) de translation parallèle au plan de référence pour passer entre les première et seconde positions, et les premières sources sont uniformément réparties le long de cet axe de translation.

## Patentansprüche

1. Umsetzer einer Änderung von zurückzugewinnender Energie in eine Potentialdifferenz zwischen zwei elektrischen Anschlüssen, wobei die Änderung der zurückzugewinnenden Energie eine Änderung eines Magnetfeldes oder einer Temperatur ist, wobei dieser Umsetzer Folgendes umfasst:
- eine Wandlerschicht (52; 110; 120; 150; 194; 240; 254; 284; 300), die sich im Wesentlichen parallel zu einer Referenzebene erstreckt und die Änderung der zurückzugewinnenden Energie in eine mechanische Verformung transformieren kann, wobei diese Wandlerschicht dazu Folgendes umfasst:
• mehrere erste Blöcke (70-73; 116-118; 126-129; 152-155; 214-217; 270; 301-304) aus magnetostriktivem oder Formgedächtnismaterial, wobei diese ersten Blöcke durch Seitenränder voneinander begrenzt sind, und
• Bereiche (76-79) ohne ersten Block, wobei diese Bereiche zwischen die Seitenränder dieser ersten Blöcke (70-73; 116-118; 126-129; 152-155; 214-217; 270; 301-304) eingefügt sind,
- eine piezoelektrische Schicht (54, 58), die aus einem einzigen Block aus piezoelektrischem Material oder mehreren Blöcken aus piezoelektrischem Material gebildet ist, die nebeneinander angefügt sind und ohne irgendeinen Freiheitsgrad aneinander befestigt sind, um sich mechanisch wie ein einziger Materialblock zu verhalten, wobei diese piezoelektrische Schicht innere und äußere Seiten aufweist, die zur Referenzebene parallel sind, wobei die innere Seite ohne irgendeinen Freiheitsgrad an der Mehrheit der Wandlerschicht befestigt ist, um eine mechanische Spannung zu erfahren, die durch diese Wandlerschicht ausgeübt wird,
- eine erste (56; 60) und eine zweite (52) Elektrode aus elektrisch leitfähigem Material, die sich im Wesentlichen parallel zur Referenzebene entlang zumindest einer der Seiten der piezoelektrischen Schicht erstrecken, um einen Überschuss von elektrischen Ladungen an einer dieser Elektroden in Reaktion auf die mechanische Spannung herbeizuführen, die durch die piezoelektrische Schicht erfahren wird, und
die ersten Blöcke (70-73; 116-118; 126-129; 152-155; 214-217; 270; 301-304) jeweils eine bevorzugte Verformungsachse aufweisen, die zur Referenzebene parallel ist.

2. Umsetzer nach Anspruch 1, wobei die ersten Blöcke aus magnetostriktivem Material hergestellt sind und Magnetostriktionskoeffizienten mit demselben Vorzeichen aufweisen und die Wandlerschicht zweite Blöcke (134-137) aus magnetostriktivem Material umfasst, die zwischen die Seitenränder der ersten Blöcke (126-129) eingefügt sind, wobei die Magnetostriktionskoeffizienten der zweiten Blöcke ein zu den Magnetostriktionskoeffizienten der ersten Blöcke entgegengesetztes Vorzeichen aufweisen.

3. Umsetzer nach Anspruch 1, wobei die ersten Blöcke (301-304) aus einem Formgedächtnismaterial hergestellt sind und alle ersten Blöcke gleichmäßig um eine Drehachse verteilt sind, die zur Referenzebene senkrecht ist, und ihre bevorzugten Verformungsachsen sich auf der Drehachse schneiden.

4. Umsetzer nach einem der vorangehenden Ansprüche, wobei der Umsetzer auch eine zweite piezoelektrische Schicht (58) umfasst, die zur ersten piezoelektrischen Schicht (54) in Bezug auf eine Symmetrieebene, die zur Referenzebene parallel ist, symmetrisch ist, wobei diese Symmetrieebene auf halber Höhe der Wandlerschicht liegt.

5. Umsetzer nach einem der vorangehenden Ansprüche, wobei jeder erste Block (70-73; 116-118; 126-129; 152-155; 214-217; 270; 301-304) in einer zur Referenzebene parallelen Ebene einen Formfaktor aufweist, der höher ist als zwei.

6. Umsetzer nach einem der vorangehenden Ansprüche, wobei die bevorzugten Verformungsachsen entlang mindestens zwei von der Referenzebene verschiedenen Richtungen verteilt sind.

7. Umsetzer nach einem der Ansprüche 1 bis 5, wobei alle ersten Blöcke gleichmäßig um eine Drehachse verteilt sind, die zur Referenzebene senkrecht ist, oder wobei alle ersten Blöcke auf einer Translationsachse gleichmäßig verteilt sind, die zur Referenzebene parallel ist.

8. Umsetzer nach einem der vorangehenden Ansprüche, wobei mindestens einer der ersten Blöcke ein Gitter von Drähten umfasst, die zur Referenzebene parallel sind, wobei die Drähte dieses Gitters aus einem magnetostriktiven Material oder aus einem Formgedächtnismaterial hergestellt sind.

9. Stromgenerator, der Folgendes umfasst:
- einen Umsetzer (20) einer Änderung von zurückzugewinnender Energie in eine Potentialdifferenz zwischen zwei elektrischen Anschlüssen, wobei die Änderung der zurückzugewinnenden Energie eine Änderung eines Magnetfeldes oder einer Temperatur ist, und
- eine Baugruppe (12; 170; 192; 252; 280; 310) von mehreren ersten Quellen (42-45; 172-175; 196-199; 256; 282; 312, 314) von zurückzugewinnender Energie, die ohne irgendeinen Freiheitsgrad aneinander befestigt sind, wobei jede erste Quelle lokal die zurückzugewinnende Energie erzeugt,
**dadurch gekennzeichnet, dass**:
- der Umsetzer einem der vorangehenden Ansprüche entspricht, und
- die Baugruppe und/oder der Umsetzer abwechselnd im Inneren der Referenzebene verlagerbar ist zwischen:
• einer ersten Position, in der die ersten Blöcke jeweils gegenüber einer ersten jeweiligen Quelle von zurückzugewinnender Energie angeordnet sind, und
• einer zweiten Position, in der die Bereiche jeweils gegenüber einer ersten jeweiligen Quelle angeordnet sind und jeder erste Block auf halbem Abstand zwischen zwei ersten Quellen liegt.

10. Generator nach Anspruch 9, wobei:
- die ersten Blöcke (70-73; 116-118; 126-129; 152-155; 214-217; 270) aus einem magnetostriktiven Material hergestellt sind und Magnetostriktionskoeffizienten mit demselben Vorzeichen aufweisen,
- die ersten Quellen Magnetfeldquellen (42-45; 172-175; 196-199; 256; 282) sind, die ohne irgendeinen Freiheitsgrad aneinander befestigt sind, wobei jede erste Quelle in der ersten Position im Inneren des ersten gegenüberliegenden Blocks Feldlinien erzeugen kann, die zur Referenzebene und zur bevorzugten Verformungsachse dieses ersten Blocks parallel sind.

11. Generator nach Anspruch 10, wobei die Baugruppe außerdem zweite Magnetfeldquellen (178-181; 202-205) umfasst, die zwischen die ersten Quellen (172-175; 196-199) eingefügt sind, wobei diese zweiten Quellen einem ersten jeweiligen Block in der zweiten Position gegenüberliegen, wobei jede zweite Quelle in der zweiten Position im Inneren des ersten gegenüberliegenden Blocks Feldlinien erzeugen kann, die zur Referenzebene parallel sind und zur bevorzugten Verformungsachse dieses ersten Blocks bis auf plus oder minus 10° senkrecht sind.

12. Generator nach Anspruch 10 oder 11, wobei die Wandlerschicht zweite Blöcke (134-137) aus magnetostriktivem Material umfasst, die zwischen die Seitenränder der ersten Blöcke (126-129) eingefügt sind, wobei jeder zweite Block in der zweiten Position einer ersten jeweiligen Magnetfeldquelle gegenüberliegt, wobei die Magnetostriktionskoeffizienten der zweiten Blöcke ein entgegengesetztes Vorzeichen zu den Magnetostriktionskoeffizienten der ersten Blöcke aufweisen.

13. Generator nach Anspruch 9, wobei:
- die ersten Blöcke (301-304) aus einem Formgedächtnismaterial hergestellt sind,
- die ersten Quellen Wärmequellen (312, 314) sind, die ohne irgendeinen Freiheitsgrad aneinander befestigt sind, wobei jede erste Quelle in der ersten Position den ersten gegenüberliegenden Block mehr als die Bereiche erhitzen kann, die auf beiden Seiten dieses ersten Blocks liegen.

14. Generator nach einem der Ansprüche 9 bis 13, wobei die Baugruppe (12; 100; 170; 252; 280; 310) von Quellen rotatorisch in Bezug auf den Umsetzer um eine Drehachse (9) verlagerbar ist, die zur Referenzebene senkrecht ist, um zwischen der ersten und der zweiten Position überzugehen, und die ersten Quellen um die Drehachse gleichmäßig verteilt sind.

15. Generator nach einem der Ansprüche 9 bis 13, wobei die Baugruppe (192) von Quellen translatorisch in Bezug auf den Umsetzer entlang einer Translationsachse (210) verlagerbar ist, die zur Referenzebene parallel ist, um zwischen der ersten und der zweiten Position überzugehen, und die ersten Quellen entlang dieser Translationsachse gleichmäßig verteilt sind.

## Claims

1. Converter of a variation of energy to be harvested into a potential difference between two electrical terminals, the variation of energy to be harvested being a variation of magnetic field or of temperature, this converter comprising:
- a transducer layer (52; 110; 120; 150; 194; 240; 254; 284; 300) extending essentially parallel to a reference plane and suitable for transforming the variation of energy to be harvested into a mechanical deformation, this transducer layer comprising, to this end:
a number of first blocks (70-73; 116-118; 126-129; 152-155; 214-217; 270; 301-304) of magnetostrictive material or material with shape memory, these first blocks being delimited from one another by lateral edges, and
regions (76-79) without any first block, these regions being inserted between the lateral edges of these first blocks (70-73; 116-118; 126-129; 152-155; 214-217; 270; 301-304),
- a piezoelectric layer (54, 58) formed from a single block of piezoelectric material or from a number of blocks of piezoelectric material attached alongside one another and fixed to one another with no degree of freedom so as to behave mechanically as a single block of material, this piezoelectric layer having inner and outer faces parallel to the reference plane, the inner face being fixed with no degree of freedom onto most of the transducer layer so as to undergo a mechanical stress exerted by this transducer layer,
- a first (56; 60) and a second (52) electrode of electrically conductive material extending essentially parallel to the reference plane along at least one of the faces of the piezoelectric layer to show an excess of electrical charges on one of these electrodes in response to the mechanical stress undergone by the piezoelectric layer,
and the first blocks (70-73; 116-118; 126-129; 152-155; 214-217; 270; 301-304) each having a preferential axis of deformation parallel to the reference plane.

2. Converter according to Claim 1, in which the first blocks are produced in magnetostrictive material and have magnetostriction coefficients of the same sign and the transducer layer comprises second blocks (134-137) of magnetostrictive material inserted between the lateral edges of the first blocks (126-129), the magnetostriction coefficients of the second blocks being of a sign opposite to the magnetostriction coefficients of the first blocks.

3. Converter according to Claim 1, in which the first blocks (301-304) are produced in material with shape memory and all the first blocks are uniformly distributed about an axis of rotation at right angles to the reference plane and their preferential axes of deformation intersect on the axis of rotation.

4. Converter according to any one of the preceding claims, in which the converter also comprises a second piezoelectric layer (58) symmetrical to the first piezoelectric layer (54) relative to a plane of symmetry parallel to the reference plane, this plane of symmetry being situated at mid-height of the transducer layer.

5. Converter according to any one of the preceding claims, in which each first block (70-73; 116-118; 126-129; 152-155; 214-217; 270; 301-304) has, in a plane parallel to the reference plane, a form factor greater than two.

6. Converter according to any one of the preceding claims, in which the preferential axes of deformation are distributed along at least two different directions of the reference plane.

7. Converter according to any one of Claims 1 to 5, in which all the first blocks are uniformly distributed about an axis of rotation at right angles to the reference plane or in which all the first blocks are uniformly distributed on a translation axis parallel to the reference plane.

8. Converter according to any one of the preceding claims, in which at least one of the first blocks comprises a lattice of wires parallel to the reference plane, the wires of this lattice being produced in magnetostrictive material or in material with shape memory.

9. Electricity generator comprising:
- a converter (20) of a variation of energy to be harvested into a potential difference between two electric terminals, the variation of energy to be harvested being a variation of magnetic field or of temperature, and
- a set (12; 170; 192; 252; 280; 310) of a number of first sources (42-45; 172-175; 196-199; 256; 282; 312, 314) of energy to be harvested fixed to one another with no degree of freedom, each first source locally generating energy to be harvested,
**characterized in that**:
- the converter conforms to any one of the preceding claims, and
- at least one of the set and of the converter can be displaced alternately, within the reference plane, between:
a first position in which the first blocks are each arranged facing a first respective source of energy to be harvested, and
a second position in which the regions are each arranged facing a first respective source and each first block is situated mid-way between two first sources.

10. Generator according to Claim 9, in which:
- the first blocks (70-73; 116-118; 126-129; 152-155; 214-217; 270) are produced in magnetostrictive material and have magnetostriction coefficients of the same sign,
- the first sources are sources (42-45; 172-175; 196-199; 256; 282) of magnetic field fixed to one another with no degree of freedom, each first source being suitable, in the first position, for generating, within the first block facing, field lines parallel to the reference plane and to the preferential axis of deformation of this first block.

11. Generator according to Claim 10, in which the set further comprises second sources (178-181; 202-205) of magnetic field, inserted between the first sources (172-175; 196-199), these second sources facing a first respective block in the second position, each second source being suitable, in the second position, for generating, within the first block facing field lines parallel to the reference plane and at right angles, to within plus or minus 10°, to the preferential axis of deformation of this first block.

12. Generator according to Claim 10 or 11, in which the transducer layer comprises second blocks (134 137) of magnetostrictive material inserted between the lateral edges of the first blocks (126 129), each second block being situated, in the second position, facing a first respective source of magnetic field, the magnetostriction coefficients of the second blocks being of a sign opposite the magnetostriction coefficients of the first blocks.

13. Generator according to Claim 9, in which:
- the first blocks (301-304) are produced in material with shape memory,
- the first sources are sources (312, 314) of heat fixed to one another with no degree of freedom, each first source being suitable, in the first position, for heating the first block facing more than the regions situated on either side of this first block.

14. Generator according to any one of Claims 9 to 13, in which the set (12; 100; 170; 252; 280; 310) of sources can be displaced in rotation, relative to the converter, about an axis (9) of rotation at right angles to the reference plane to pass between the first and second positions, and the first sources are uniformly distributed about the axis of rotation.

15. Generator according to any one of Claims 9 to 13, in which the set (192) of sources can be displaced in translation, relative to the converter, along an axis (210) of translation parallel to the reference plane to pass between the first and second positions, and the first sources are uniformly distributed along this axis of translation.
